# EUROPÄISCHE PATENTSCHRIFT

(11) **EP 0 984 312 B1**
(45) Veröffentlichungstag und Bekanntmachung des Hinweises auf die Patenterteilung: **16.04.2008**
(21) Anmeldenummer: 99116255.3
(22) Anmeldetag: 18.08.1999
(51) Int. Cl.: G02B 27/09, H01S 5/40, B41J 2/45

(54) **Laserdiodenanordnung**
Laser diode assembly
Ensemble diode laser

(30) Priorität: 02.09.1998 DE 19839902
(43) Veröffentlichungstag der Anmeldung: 08.03.2000
(73) Patentinhaber: Laserline Gesellschaft für Entwicklung und Vertrieb von Diodenlasern GmbH, 56070 Koblenz (DE)
(72) Erfinder: Ullmann, Christoph, Dr., 53604 Bad Monnef (DE); Krause, Volker, 56203 Höhr-Grenzhausen (DE)
(74) Vertreter: Graf, Helmut

(56) Entgegenhaltungen:
- DE-A- 19 705 574
- DE-A- 19 722 592
- DE-A- 19 751 106
- US-A- 5 861 992

## Beschreibung

Die Erfindung bezieht sich auf eine Laserdiodenanordnung.

Die Strahlung eines Halbleiter-Diodenlasers (hier vereinfacht auch Diodenlaser) ist durch einen stark divergierenden Strahl gekennzeichnet ist, und zwar im Gegensatz zu anderen konventionellen Laserstrahlquellen, deren Laserstrahl einen Durchmesser von wenigen Millimetern mit einer geringen Strahldivergenz im Bereich von wenigen mrad aufweist, während die Divergenz bei einem Diodenlaser größer als 1000 mrad ist.

Weiterhin ist bekannt, dass bei Diodenlasern der Divergenzwinkel in der Ebene senkrecht zur aktiven Schicht, d.h. in der sogenannten "Fast-Axis" größer ist als in der Ebene der aktiven Schicht bzw. in der sogenannten "Slow-Axis".

Um die Strahlung eines Diodenlasers, der wenigstens einen Diodenlaserbarren mit mehreren in einer ersten Koordinatenrichtung aufeinander folgenden, Laserlicht aussendenden Emittern aufweist, voll nutzen zu können, ist es bekannt (DE-A-197 05 574), kollimierende und fokussierende optische Anordnungen zu verwenden. Diese optischen Anordnungen umfassen insbesondere einen als Mikrooptik ausgeführten Fast-Axis-Kollimator, der von einer Zylinderlinse gebildet ist, welche mit ihrer Achse ebenfalls in der ersten Koordinatenrichtung liegt. Für sämtliche Emitter eines Diodenlaserbarrens ist dabei jeweils eine eigenen durchgehende Zylinderlinse vorgesehen, und zwar mit kleiner Brennweite in unmittelbarer Nähe der Facette des Diodenlaserbarrens, d.h. in einem Abstand von einigen hundert µm von den Emittern bzw. von dieser Facette.

Zur Erzeugung einer Laserstrahlung höherer Leistung (z.B. für Materialbearbeitung, für die Medizintechnik, für das Pumpen von FK-Lasern usw.) ist es weiterhin auch bekannt, mehrere Diodenlaserbarren in einem Diodenlaserstapel in mehreren Stapellagen übereinander vorzusehen, wobei dann dem Diodenlaserbarren jeder Stapellage ein eigener Fast-Axis-Kollimator zugeordnet ist.

Eine optimale Fast-Axis-Kollimation erfordert eine möglichst parallele Ausrichtung der einzelnen Strahlen der Emitter des jeweiligen Barrens, damit sich die Emitter nach der Kollimation auf einer möglichst geraden Linie abbilden. Dies ist aber in der Regel in idealer Form nicht realisierbar, und zwar wegen Nicht-Konformitäten, d.h. Abweichungen der Konformität zwischen Diodenlaserbarren und Fast-Axis-Kollimator. Diese Abweichungen können unterschiedlichen Ursprungs sein, beispielsweise bedingt durch Fertigungstoleranzen und/oder durch Verformungen bei der Montage usw.. Solche Nicht-Konformitäten führen dann beispielsweise dazu, dass sich die Emitter des Diodenlaserbarrens nicht auf der geraden, sondern auf einer gekrümmten Linie (sogenannter Smile-Effekt) oder aber als elliptische oder kissenartige Fläche abbilden. Diese Abbildungsfehler sind in der Regel unerwünscht, da sie beispielsweise zur Vergrößerung eines gemeinsamen Brennfleckes führen.

Bekannt ist eine optische Anordnung zur Abbildung mehrerer in eine Reihe angeordneter Emitter einer Laserdiodenanordnung in einem gemeinsamen Raumbereich oder Brennfleck (DE 197 22 592).

Bei dieser bekannten Anordnung sind Emitter mit ihrer aktiven Schicht nicht in einer gemeinsamen Ebene angeordnet, sondern jeweils abwechselnd in einer von zwei in Richtung senkrecht zur aktiven Schicht versetzten Ebenen. Um dennoch eine Fast-Axis-Korrektur mit ausreichender Qualität zu erreichen, besteht der Fast-Axis-Kollimator aus einer Vielzahl von Zylinderlinsensegmenten, von denen jeweils eines für jeden Emitter vorgesehen ist und die einen dem Versatz der Emitter entsprechenden Versatz in der Fast-Axis relativ zueinander aufweisen. Eine Korrektur des Smile-Effektes ist mit dieser bekannten optischen Anordnung nicht angestrebt.

Bekannt ist ferner aus der Veröffentlichung Proc. of SPIE, Vol. 3000, Laser Diode and LED Applications III, 10-11 Feb. 1997, San Jose, CA, USA Seite 209-214 eine Korrekturvorrichtung zur Korrektur des Strahlprofils von Laser diode arrays, insbesondere zur Korrektur des Smile Effektes, welche eine mittels eines piezo-elektrischen Stellgliedes verformbare Faserlinse aufweist. Nachteilig ist bei dieser Vorrichtung lediglich eine Korrektur in einer Koordinatenachse möglich, und nur bezüglich der gesamten Linse.

Aufgabe der Erfindung ist es, eine optische Anordnung der eingangs erwähnten Art so auszubilden, dass Abbildungsfehler auch entsprechend dem Smile-Effekt vermieden werden. Zur Lösung dieser Aufgabe ist eine Laserdiodenanordnung entsprechend dem Patentanspruch 1 vorgesehen.

Durch die Aufteilung des Fast-Axis-Kollimators der wenigstens einen Reihe von Emittern in mehrere Kollimatorsegmente können durch die Nicht-Konformität zwischen Diodenlaserbarren und Fast-Axis-Kollimator bedingte Abbildungsfehler nahezu vollständig korrigiert werden.

Weiterbildungen der Erfindung sind Gegenstand der Unteransprüche.

Die Erfindung wird im Folgenden anhand der Figuren an Ausführungsbeispielen näher erläutert. Es zeigen:
- Fig. 1: in vereinfachter Darstellung und in Seitenansicht eine Laserdiodenanordnung mit mehreren, in der Zeichenebene (X-Z- Ebene) der Figur 1 in einer Koordinatenrichtung (X-Achse) übereinander angeordneten Diodenlaserbarren, die jeweils senkrecht zur Zeichenebene der Figur (Y-Achse) aufeinander folgende Emitter aufweisen, sowie mit einer optischen Anordnung zur Kollimation und Fokussierung der Strahlen der einzelnen Emitter in einem gemeinsamen Brennfleck;
- Fig. 2: in vereinfachter Darstellung eine Draufsicht auf eine Stapelebene der Laserdiodenanordnung der Figur 1 bei einer Ausbildung gemäß dem Stand der Technik;
- Fig. 3 und 4: jeweils in vereinfachter Darstellung die Abbildung der in der Fast-Axis sowie in der Slow-Axis kollimierten Laser-Strahlung des Diodenlaser-Barrens der Ebene der Figur 2 bei zwei unterschiedlichen typischen Nicht-Konformitäten;
- Fig. 5: in einer Darstellung ähnlich der Figur 2 eine erste, mögliche Ausführungsform der Erfindung;
- Fig. 6 und 7: jeweils eine Abbildung der kollimierten Laserstrahlung der Laserdiodenanordnung der Figur 5 bei den typischen Nicht-Konformitäten;
- Fig. 8 - 10: in vergrößerter Teildarstellung den Diodenlaserstapel der Ausführung der Figur 5 in Draufsicht, in Seitenansicht sowie in Stirnansicht mit Blick auf die Fast-Axis-Kollimatoren;
- Fig. 11: eine Darstellung wie Figur 5 bei einer weiteren möglichen Ausführungsform;
- Fig. 12 und 13: die Abbildung der kollimierten Laserstrahlung des Diodenlaserbarrens der Stapellage der Figur 11 bei den typischen Nicht-Konformitäten;
- Fig. 14 und 15: den Diodenlaserstapel der Ausführungsform der Figur 11 in Seitenansicht sowie in Stirnansicht auf die Fast-Axis-Kollimatoren.

In den Figuren sind zur einfacheren Orientierung und Beschreibung jeweils mit X, Y und Z die drei senkrecht zueinander verlaufenden Raumachsen oder Koordinatenrichtungen, nämlich die X-Achse, Y-Achse und Z-Achse bezeichnet.

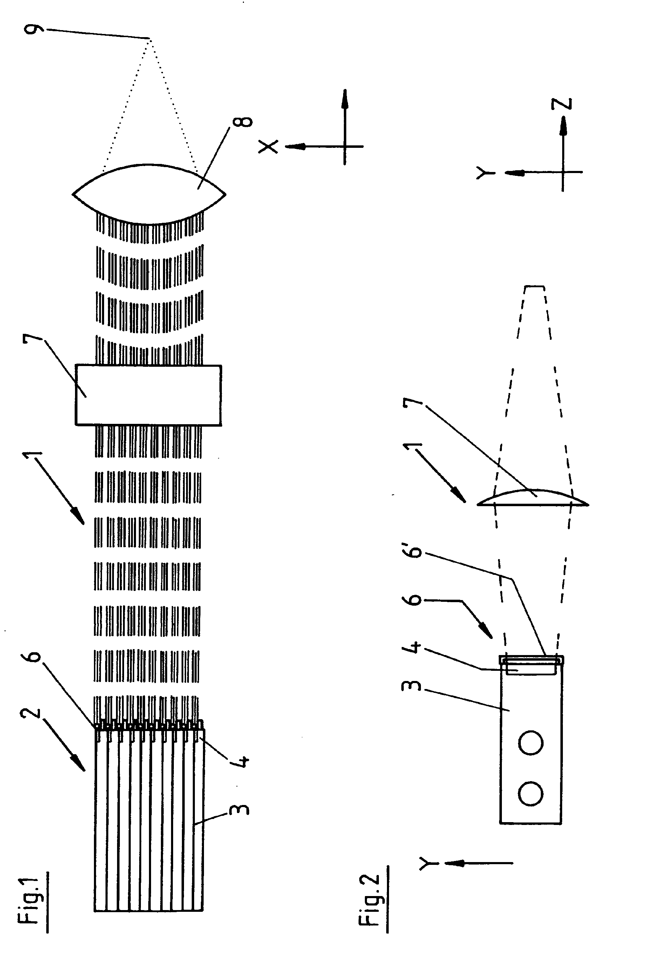

In den Figuren 1 und 2 ist 1 eine Diodenlaseranordnung für hohe Leistung. Diese besteht u.a. aus dem Diodenlaserstapel 2, der von mehreren stapelartig übereinander angeordneten und jeweils als Wärmesenke ausgebildeten Substraten 3 besteht, die jeweils an einer gemeinsamen Seite des Stapels mit einem Diodenlaserbarren 4 versehen sind, von denen jeder Barren 4 eine Vielzahl von Laserlicht aussenden Emittern 5 aufweist und monolithisch von einem Halbleiterchip gebildet ist. Bei der für die Figuren gewählten Orientierung der X-, Y- und Z-Achsen schließen die Substrate 3 in Richtung der X-Achse im Stapel aneinander an. Die Diodenlaserbarren 4 strecken sich in Richtung der Y-Achse, d.h. senkrecht zur Zeichenebene der Figur 1. In dieser Achsrichtung folgen auch die einzelnen Emitter 5 in jedem Barren 4 aufeinander. Die aktive Schicht der Emitter 5 liegt in der Y-Z-Ebene.

Die einzelnen Emitter 5 liefern einen Laserstrahl, der sowohl in der Fast-Axis, d.h. in der X-Achse bzw. in der X-Z-Ebene, als auch in der Slow-Axis, d.h. in der Y-Achse bzw. in der Y-Z-Ebene eine Divergenz aufweisen. Zur Behebung dieser Strahldivergenz werden optische Korrekturelemente verwendet, und zwar insbesondere unmittelbar an dem jeweiligen Diodenlaserbarren 4 ein Fast-Axis-Kollimator 6 beispielsweise in Form einer Mikro-Zylinderlinse 6', die mit ihrer Achse in Richtung der Y-Achse und damit parallel zu der Längserstreckung bzw. der Facette des jeweiligen Diodenlaserbarrens 4 angeordnet ist. Für jede von einem Substrat 3 mit Diodenlaserbarren 4 gebildete Stapellage oder -ebene ist ein gesonderter Fast-Axis-Kollimator 6 vorgesehen.

Wegen der geringen Abstände zwischen den einzelnen Diodenlaserbarren 4 bzw. der einzelnen Stapelebenen (in Richtung der X-Achse) ist für die als Fast-Axis-Kollimatoren verwendeten Zylinderlinsen 6' eine kurze Brennweite von einigen hundert µm bis zu wenigen mm notwendig.

Auf die Fast-Axis-Kollimatoren 6 in Strahlrichtung, d.h. in Richtung der Z-Achse folgend ist ein weiteres optisches Element 7, insbesondere für die Slow-Axis-Kollimation vorgesehen, und zwar beispielsweise in einfachster Form als Makro-Zylinderlinse, die mit ihrer Achse in Richtung der X-Achse orientiert ist. Auf den Slow-Axis-Kollimator 7 folgt in der Figur 1 in Strahlungsrichtung (Z-Achse) eine Fokussieroptik 8, mit der die einzelnen Emitter 5 des Diodenlaserstapels 2 in einem gemeinsamen Brennfleck 9 abgebildet werden.

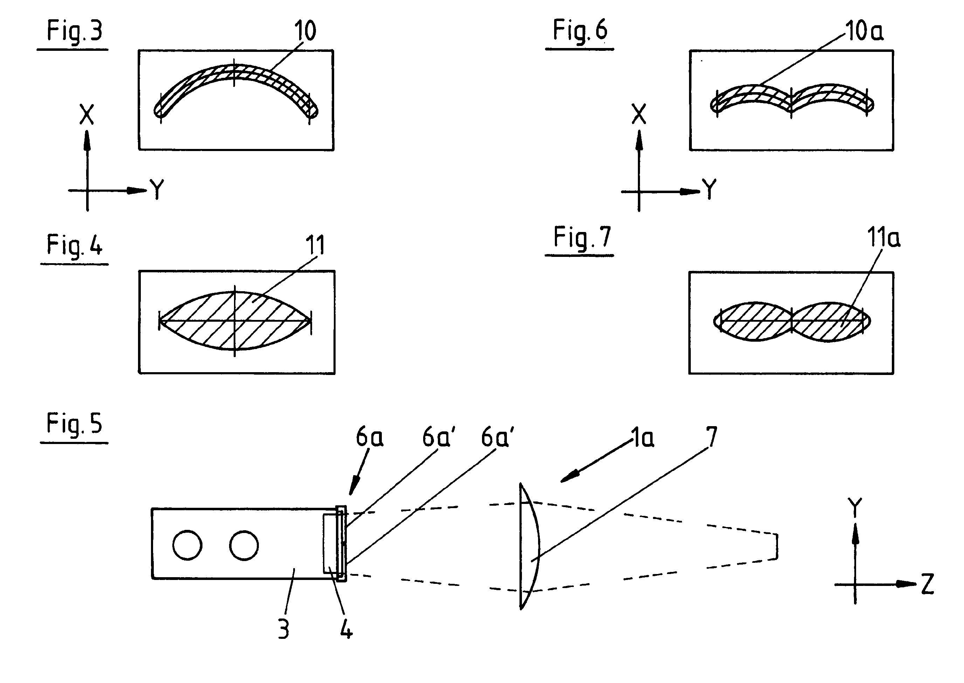

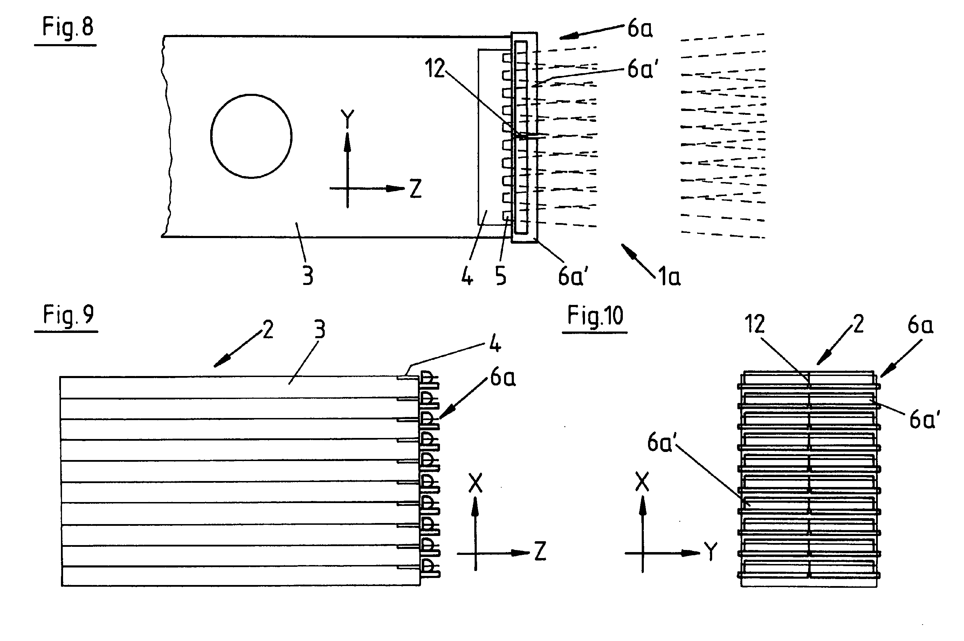

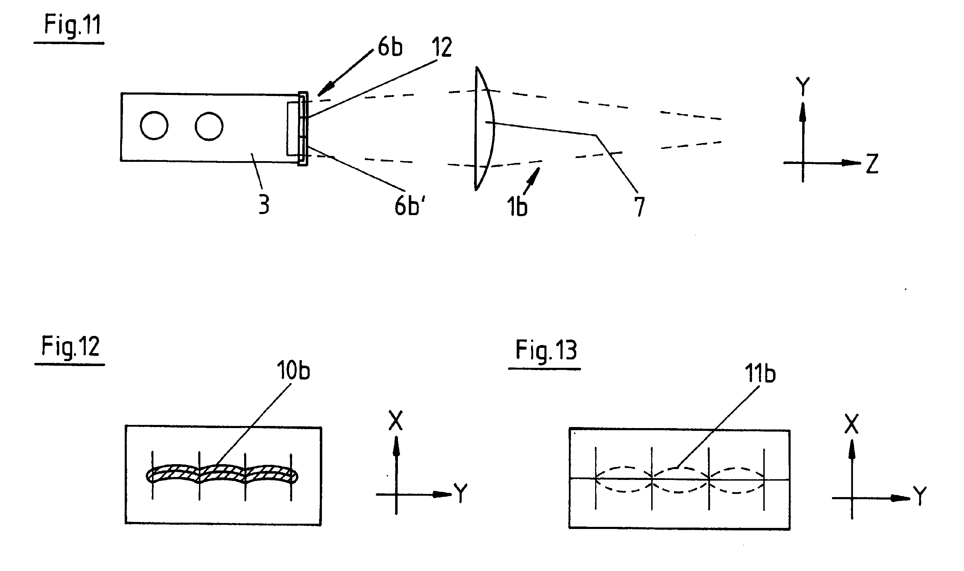

Nachteilig ist bei dieser bekannten Diodenlaseranordnung ist, daß die Fast-Axis-Kollimatoren 6 bzw. die diese Kollimatoren bildenden Zylinderlinsen 6' jeweils durchgehend für jeden Diodenlaserbarren 4 ausgeführt sind. Die Justage der Fast-Axis-Kollimatoren 6 erfolgt zwar so, daß die Ausrichtung der Achse der jeweiligen durchgehenden Zylinderlinse 6' zur Achse des zugehörigen Barrens 4 eine möglichst parallele Ausrichtung der Strahlen der einzelnen Emitter 5 zu der Y-Z-Ebene sicherstellt, in der Praxis sind aber erhebliche Abweichungen von einer idealen Justage nicht zu vermeiden, und zwar beispielsweise bedingt durch eine Formabweichung (Nicht-Konformität) zwischen dem jeweiligen Barren 4 und dem Fast-Axis-Kollimator 6. Diese Nicht-Konformität kann z.B. durch eine geringe Deformierung der Substrate 3 und damit auch der Laserbarren 4 beim Verspannen dieser Substrate zum Diodenlaserstapel 2 oder auch durch Toleranzen bei der Fertigung der Substrate 3 mit den Diodenlaserbarren 4 und/oder der Fast-Axis-Kollimatoren 6 usw. bedingt sein. Bei derartigen Nicht-Konformitäten ergibt sich auch bei optimaler Justage nach der Fast-Axis-Kollimation mit der durchgehenden Zylinderlinse 6' nicht die angestrebte ideale Abbildung des aktivierten bzw. Laserlicht aussendenden Barrens 4 in der X-Y-Ebene als gerade Linie, sondern z.B. entsprechend den Fig. 3 und 4 eine fehlerhafte Abbildung 10 bzw. 11.

Bei der Darstellung der Fig. 3 wurde davon ausgegangen, daß Nicht-Konformitäten derart vorliegen, daß die Achse der Zylinderlinse 6' und/oder des Barrens 4 um die Z-Achse gekrümmt ist, so daß sich eine deformierte Abbildung in Form einer gekrümmten Linie 10 ergibt. Dieser Abbildungsfehler wird auch als "Smile-Effekt" bezeichnet. Bei der Darstellung der Figur 4 wurde davon ausgegangen, daß die Nicht-Konformitäten in einer Krümmung beispielsweise der Achse der Zylinderlinse 6' und/oder der Facette des Barrens 4 um die X-Achse besteht, so daß sich eine deformierte Abbildung 11 in Form einer elliptischen Fläche ergibt.

Derartige Abbildungsfehler kommen besonders stark bei der gestapelten Ausführung zum Tragen kommt, da wegen des geringen Abstandes der einzelnen Stapelebenen in Richtung der X-Achse die Brennweite der Zylinderlinsen 6' begrenzt ist. Die Abbildungsfehler führen dann dazu, daß es im gemeinsamen Brennfleck 9 zu einer Überlagerung von deformierten Abbildungen der aktivierten Barren 4 kommt und damit zu einer erheblichen Verbreiterung des Brennflecks 9 insbesondere in der X-Achse.

Mit der Erfindung wird dieser vorbeschriebene Fehler der Fast-Axis-Kollimationen behoben. Hierfür ist bei der Diodenlaseranordnung 1a der Figuren 5 - 10 ein Fast-Axis-Kollimator 6a verwendet, der aus mehreren in Richtung der Y-Achse aneinander anschließenden Segmenten, d.h. bei der Diodenlaseranordnung 1a aus zwei Segmenten bzw. Zylinderlinsen 6a' besteht. Wie in den Figuren 6 und 7 dargestellt, wird durch diese Aufteilung jedes Fast-Axis-Kollimators 6a in zwei Segmente sowohl der Abbildungsfehler 10, als auch der Abbildungsfehler 11 in seiner Wirkung stark reduziert, d.h. die Abbildung 10a bzw. 11a der Diodenlaserbarren 4 ist trotz bestehender Nicht-Konformitäten stark an die Idealform einer geraden Linie angepaßt. Um dies möglichst optimal zu erreichen, sind die beiden Zylinderlinsen 6a' jedes Kollimators 6a individuell bei der Montage justierbar.

Die beiden Segmente bzw. Zylinderlinsen 6a' jedes Kollimators 6a sind geringfügig voneinander beabstandet und bilden zwischen sich einen Spalt 12. Die Breite dieses Spalts ist möglichst gering. Weiterhin ist der Spalt 12 so positioniert, daß er mittig zwischen zwei Emittern 5 liegt (z.B. Figur 8), so daß sämtliche Emitter 5 auf nutzbare Flächen der Zylinderlinsen 6a' strahlen. Durch die mit der Segmentierung der Kollimatoren 6a erreichte Korrektur wird eine wesentliche Verbesserung der Strahlqualität in der Y-Z-Ebene erreicht und insbesondere auch eine Vergrößerung des gemeinsamen Brennfleckes 9 in der X-Achse vermieden.

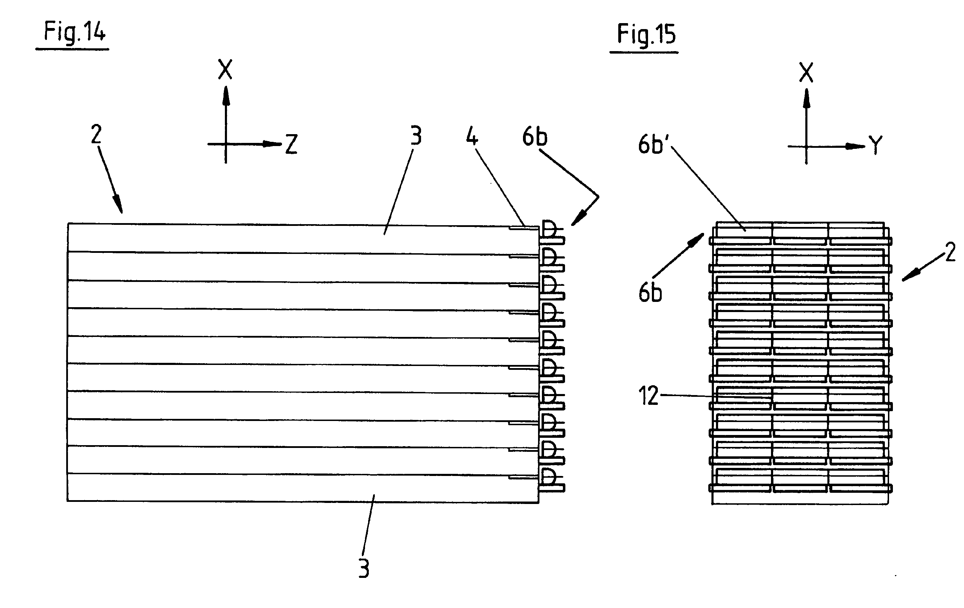

Die Figuren 11 - 15 zeigen als weitere mögliche Ausführungsform eine Diodenlaseranordnung 1 b, die sich von der Diodenlaseranordnung 1a dadurch unterscheidet, daß jeder Fast-Axis-Kollimator 6b aus drei in Richtung der Y-Achse aufeinander folgenden Segmenten besteht, die bei der dargestellten Ausführungsform wiederum jeweils von einer Zylinderlinse 6b' gebildet sind. Zwischen den Zylinderlinsen sind möglichst schmale Spalte 12 vorgesehen, die wiederum so positioniert sind, daß jeder Spalt 12 mittig zwischen zwei Emittern 5 liegt und sämtliche Emitter 5 auf nutzbare Linsenflächen der Zylinderlinsen 6b' strahlen. Mit den dreifach segmentierten Kollimatoren 6b lassen sich auch komplexere Nicht-Konformitäten bzw. Formabweichungen zwischen dem jeweiligen Diodenlaserbarren 4 und dem zugehörigen Fast-Axis-Kollimator 6b korrigieren (Abbildungungen 10b bzw. 11b der Fig. 12 und 13).

Die Erfindung wurde voranstehend an Ausführungsbeispielen beschrieben. Es versteht sich, daß zahlreiche Änderungen sowie Abwandlungen möglich sind, ohne daß dadurch der der Erfindung zugrundeliegende Erfindungsgedanke verlassen wird.

### Bezugszeichenliste

- 1, 1a, 1b: Diodenlaseranordnung
- 2: Diodenlaserstapel
- 3: Substrat bzw. Wärmesenke
- 4: Diodenlaserbarren
- 5: Emitter
- 6, 6a, 6b: Fast-Axis-Kollimator
- 6', 6a', 6b': Zylinderlinse
- 7: Makrooptik, insbesondere auch für die Slow-Axis-Kollimation
- 8: Fokussieroptik
- 9: Brennfleck
- 10, 11: deformierte Abbildung
- 10a, 10b, 11a, 11b: korrigierte Abbildung
- 12: Spalt

## Patentansprüche

1. Laserdiodenanordnung mit wenigstens einem Diodenlaserbarren, der in einer ersten Koordinatenrichtung (Y-Achse) mehrere Emitter (5) aufeinander folgend aufweist, und mit einer optischen Anordnung zur Abbildung der in wenigstens einer Reihe (4) angeordneter Emitter (5) in einem gemeinsamen Raumbereich oder Brennfleck (9), wobei die Emitter (5) in wenigstens einer Reihe an einem gemeinsamen Diodenlaserbarren mit ihrer aktiven Schicht in einer ersten Koordinatenrichtung (Y-Achse) aufeinander folgend und senkrecht zu einer zweiten Koordinatenrichtung (X-Achse) angeordnet sind, die ihrerseits senkrecht zur ersten Koordinatenrichtung (Y-Achse) orientiert ist, wobei durch die Emitter (5) eine sich in einer dritten Koordinatenrichtung (Z-Achse) ausbreitende Laserstrahlung erzeugt wird und die dritte Koordinatenrichtung (Z-Achse) senkrecht zur ersten und zweiten Koordinatenrichtung (Y-Achse, Z-Achse) orientiert ist,
wobei die optische Anordnung für die Emitter (5) der wenigstens einen Reihe (4) zur Kollimation der Laserstrahlung in der zweiten Koordinatenrichtung (X-Achse) einen Fast-Axis-Kollimator (6a, 6b) mit der optischen Eigenschaft einer Zylinderlinse aufweist, wobei der Fast-Axis-Kollimator (6a, 6b) für jede Reihe (4) von Emittern (5) segmentiert ist und aus mehreren in der ersten Koordinatenrichtung (Y-Achse) aufeinander folgenden zur Kollimation vorgesehenen Zylinderlinsen (6a', 6b') besteht, bei der
der Fast-Axis-Kollimator (6a, 6b) der wenigstens einen Reihe von Emittern (5) aus zwei oder drei getrennt voneinander angeordneten Zylinderlinsen (6a', 6b') besteht, wobei jeweils eine Zylinderlinse (6a', 6b') zur Abbildung mehrerer Emitter (5) in den gemeinsamen Raumbereich oder Brennfleck (9) vorgesehen ist und dass die Zylinderlinsen (6a', 6b') des Fast-Axis-Kollimators (6a, 6b) jeder Reihe (4) von Emittern (5) bezüglich der zweiten Koordinatenrichtung (X-Achse) und der dritten Koordinatenrichtung (Z-Achse) unabhängig justiert und fixiert sind.

2. Laserdiodenanordnung nach Anspruch 1, **dadurch gekennzeichnet, dass** ein Anschlussbereich oder Spalt (12) zwischen zwei aufeinander folgenden Zylinderlinsen (6a', 6b') zwischen zwei Emittern (5), vorzugsweise in der Mitte oder in etwa in der Mitte zwischen zwei Emittern (5) vorgesehen ist.

3. Laserdiodenanordnung nach Anspruch 1 oder 2, **dadurch gekennzeichnet, dass** mehrere Reihen (4) von Emittern (5) in der zweiten Koordinatenrichtung (X-Achse) aufeinander folgend in einem Diodenlaserstapel (2) vorgesehen sind, und dass jeder Reihe (4) von Emittern (5) ein eigener, segmentierter Fast-Axis-Kollimator (6a, 6b) zugeordnet ist.

4. Laserdiodenanordnung nach einem der vorhergehenden Ansprüche, **gekennzeichnet durch** wenigstens eine weitere, in Richtung der Strahlachse (Z-Achse) auf den wenigstens einen Fast-Axis-Kollimator (6a, 6b) folgende optische Einrichtung (7) zur Strahl-Formung, insbesondere zur Siow-Axis-Kollimation.

5. Laserdiodenanordnung nach einem der vorhergehenden Ansprüche, **gekennzeichnet durch** eine Fokussieroptik (8) zum Abbilden der Reihen (4) von Emittern (5) in einem gemeinsamen Brennfleck (9).

## Claims

1. Laser diode arrangement with at least one diode laser bar which has several emitters (5) in succession in a first coordinate direction (Y-axis), and with an optical arrangement for imaging the emitters (5) which are arranged in at least one row (4) in a common spatial area or focal spot (9), wherein the emitters (5) are arranged in succession in at least one row on a common diode laser bar with their active layer in a first coordinate direction (Y-axis) and perpendicular to a second coordinate direction (X-axis) which in turn is aligned perpendicular to the first coordinate direction (Y-axis), wherein a laser beam is produced through the emitters (5) to spread out in a third coordinate direction (Z-axis) and the third coordinate direction (Z-axis) is aligned perpendicular to the first and second coordinate directions (Y-axis, X-axis), wherein the optical arrangement for the emitters (5) of the at least one row (4) has for the collimation of the laser beam in the second coordinate direction (X-axis) a fast-axis collimator (6a, 6b) with the optical property of a cylinder lens wherein the fast-axis collimator (6a, 6b) is segmented for each row (4) of emitters (5) and consists of several cylinder lenses (6a', 6b') which are provided for the collimation and are arranged in succession in the first coordinate direction (Y-direction)
wherein the fast-axis collimator (6a, 6b) of the at least one row of emitters (5) consists of two or three cylinder lenses (6a', 6b') which are arranged separated from one another wherein each one cylinder lens (6a', 6b') is provided for imaging several emitters (5) into the common spatial area or focal point (9) and that the cylinder lenses (6a', 6b') of the fast-axis collimator (6a, 6b) of each row (4) of emitters (5) are adjusted and fixed independently in relation to the second coordinate direction (X-axis) and the third coordinate direction (Z-axis).

2. Laser diode arrangement according to claim 1 **characterised in that** a connecting area or gap (12) is provided between two successively arranged cylinder lenses (6a', 6b') between two emitters (5), preferably in the centre or substantially in the centre between two emitters (5).

3. Laser diode arrangement according to claim 1 or 2 **characterised in that** several rows (4) of emitters (5) are provided in succession in the second coordinate direction (X-axis) in a diode laser stack (2) , and that each row (4) of emitters(5) is assigned its own segment fast-axis collimator (6a, 6b).

4. Laser diode arrangement according to one of the preceding claims, **characterised by** at least one further optical device (7) for beam formation, more particularly for slow-axis collimation, which follows the at least one fast-axis collimator (6a, 6b) in the direction of the beam axis (Z-axis).

5. Laser diode arrangement according to one of the preceding claims **characterised by** a focussing optic (8) for imaging the rows (4) of emitters (5) in a common focal point (9).

## Revendications

1. Assemblage de diodes laser avec au moins une barre de diodes laser qui, dans un premier sens de coordonnées (axe Y) présente plusieurs émetteurs (5) l'un à la suite de l'autre, et avec un assemblage optique pour la projection des émetteurs (5) agencés en au moins une matrice (4) dans un domaine spatial commun ou foyer (9), les émetteurs (5) dans au moins une matrice sur une barre commune de diodes lasers étant agencés avec leur couche active dans un premier sens de coordonnées (axe Y) les uns à la suite des autres et à la verticale d'un deuxième sens de coordonnées (axe X), lequel de son côté est orienté à la verticale du premier sens de coordonnées (axe Y), un rayon laser s'étendant dans un troisième sens de coordonnées (axe Z) étant produit par les émetteurs (S), et le troisième sens de coordonnées (axe Z) étant orienté à la verticale du premier et du deuxième sens de coordonnées (axe Y, axe X),
l'assemblage optique pour les émetteurs (5) de la au moins une matrice (4) présentant, pour la collimation du rayon laser dans le deuxième sens de coordonnées (axe X), un collimateur de l'axe rapide (6a, 6b) ayant la propriété optique d'une lentille cylindrique, le collimateur de l'axe rapide (6a, 6b) étant segmenté pour chaque matrice (4) d'émetteurs (5) et étant constitué de plusieurs lentilles cylindriques (6a', 6b') prévues dans le premier sens de coordonnées (axe Y) l'une à la suite de l'autre pour la collimation,
dans lequel le collimateur de l'axe rapide (6a, 6b) de la au moins une matrice d'émetteurs (5) est constitué de deux ou de trois lentilles cylindriques (6a', 6b') séparées l'une de l'autre
chaque fois une lentille cylindrique (6a', 6b') étant prévue pour la projection de plusieurs émetteurs (5) dans le domaine spatial commun ou foyer (9) et les lentilles cylindriques (6a', 6b') du collimateur de l'axe rapide (6a, 6b) de chaque matrice (4) d'émetteurs (5) lesquelles se rapportent au deuxième sens de coordonnées (axe X) et au troisième sens de coordonnées (axe Z),
étant réglées et fixées indépendamment.

2. Assemblage de diodes laser selon la revendication 1, **caractérisé en ce qu'**une zone de connexion ou intervalle (12) entre deux lentilles cylindriques successives (6a', 6b') entre deux émetteurs (5), de préférence au centre ou à peu près au centre entre deux émetteurs (5), est prévue.

3. Assemblage de diodes laser selon la revendication 1 ou 2, **caractérisé en ce que** plusieurs matrices (4) d'émetteurs (5) sont prévues dans le deuxième sens de coordonnées (axe X) les unes après les autres dans un empilement de lasers à diode (2) et **en ce que** chaque matrice (4) d'émetteurs (5) reçoit un collimateur de l'axe rapide (6a, 6b) qui lui est propre et qui est segmenté.

4. Assemblage de diodes laser selon l'une des revendications précédentes, **caractérisé par** au moins un autre dispositif optique (7) de formation de rayons suivant le sens de l'axe de rayonnement (axe Z) sur le au moins un collimateur de l'axe rapide (6a, 6b), en particulier pour la collimation d'axe lent.

5. Assemblage de diodes laser selon l'une des revendications précédentes, **caractérisé par** une optique de focalisation (8) pour la projection des matrices (4) d'émetteurs (5) dans un foyer commun (9).
